(19) Europäisches Patentamt
European Patent Office
Office européen des brevets

(11) **EP 2 106 331 B1**

(12) **EUROPÄISCHE PATENTSCHRIFT**

(45) Veröffentlichungstag und Bekanntmachung des Hinweises auf die Patenterteilung:
**01.02.2012 Patentblatt 2012/05**

(21) Anmeldenummer: **08850859.3**

(22) Anmeldetag: **14.11.2008**

(51) Int Cl.:
**B28D 5/00** (2006.01)          **H01L 21/78** (2006.01)

(86) Internationale Anmeldenummer:
**PCT/EP2008/009676**

(87) Internationale Veröffentlichungsnummer:
**WO 2009/062744 (22.05.2009 Gazette 2009/21)**

(54) **VERFAHREN ZUM TRENNEN VON EINKRISTALLINEN SCHICHTEN, SCHEIBEN ODER WAFERN**

METHOD FOR DIVIDING OF MONOCRYSTALLINE LAYERS, DISKS OR WAFERS

PROCÉDÉ DE DÉCOUPAGE DES COUCHES, DES DISQUES OU DES TRANCHES MONOCRISTALLINES

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **15.11.2007 DE 102007056115**
**15.11.2007 US 996396 P**

(43) Veröffentlichungstag der Anmeldung:
**07.10.2009 Patentblatt 2009/41**

(60) Teilanmeldung:
**11174244.1 / 2 377 662**

(73) Patentinhaber: **Freiberger Compound Materials GmbH**
**09599 Freiberg (DE)**

(72) Erfinder:
• **HAMMER, Ralf**
**09599 Freiberg (DE)**
• **JURISCH, Manfred**
**01217 Dresden (DE)**

(74) Vertreter: **Prüfer & Partner GbR**
**European Patent Attorneys**
**Sohnckestrasse 12**
**81479 München (DE)**

(56) Entgegenhaltungen:
EP-A2- 0 961 328     US-A- 5 198 069
US-B1- 6 252 197

• **BELSINGER H E JR ET AL: "A fracture criterion for gallium arsenide wafers" ENGINEERING FRACTURE MECHANICS UK, Bd. 48, Nr. 2, Mai 1994 (1994-05), Seiten 199-205, XP002518266 ISSN: 0013-7944**
• **PATERSON N ET AL: "On the numerical modelling of laser shearing of glass sheets used to optimize production methods" PROCEEDINGS OF THE INSTITUTION OF MECHANICAL ENGINEERS. PART C, JOURNAL OF MECHANICAL ENGINEERING SCIENCE, MECHANICAL ENGINEERING PUBLICATIONS, LONDON, GB, Bd. 218, Nr. 1, 1. Januar 2004 (2004-01-01), Seiten 1-11, XP008102816 ISSN: 0954-4062**
• **FABER K T ET AL: "Crack deflection processes-I. Theory" ACTA METALLURGICA, PERGAMON PRESS, US, Bd. 31, Nr. 4, 1. April 1983 (1983-04-01), Seiten 565-576, XP024029596 ISSN: 0001-6160 [gefunden am 1983-04-01]**
• **HAMMER R ET AL: "Material-related fundamentals of cutting techniques for GaAs wafer manufacturing" ZEITSCHRIFT FUR METALLKUNDE CARL HANSER GMBH GERMANY, Bd. 96, Nr. 7, Juli 2005 (2005-07), Seiten 787-793, XP008102819 ISSN: 0044-3093**
• **"Cleaved GaN facets by wafer fusion of GaN to InP", APPLIED PHYSICS LETTERS, AIP, AMERICAN INSTITUTE OF PHYSICS, MELVILLE, NY, US, vol. 68, no. 15, 8 April 1996 (1996-04-08), pages 2147-2149, XP012015030, ISSN: 0003-6951, DOI: DOI:10.1063/1.115613**

EP 2 106 331 B1

**Beschreibung**

Die Erfindung betrifft ein Verfahren zum Trennen von einkristallinen Scheiben beziehungsweise Wafern oder Teilen davon. Insbesondere betrifft die Erfindung ein Verfahren zum Trennen von Einkristallen mit selbstjustierender Rissausbreitung.

Einkristalline Wafer aus halbleitenden Materialien werden als Substrate für die Herstellung von mikroelektronischen Bauelementen wie z.B. Feldeffekt- und Heterobipolar-Tansistoren bzw. optoelektronischen Bauelementen wie Laser- und Lumineszenzdioden verwendet. Auf diesen Substraten werden durch verschiedene Verfahren wie CVD, MOCVD, LPE, MBE die Funktionsschichten abgeschieden und gegebenenfalls nachbearbeitet oder durch Ionenimplantation im Substrat erzeugt. Sie durchlaufen dann komplexe Strukturierungsprozesse unter mehrfacher Verwendung von Belichtungsmasken.

Für die Ausrichtung (Justage) der Belichtungsmasken und die gegebenenfalls erforderliche Unterscheidung von Vorder- und Rückseite weist das Substrat ein sogenanntes Orientierungflat (OF) und ein um 90˚ gegen dieses im Uhrzeiger- oder Gegenuhrzeigersinn versetztes Identifikationsflat (IF) auf. Die Wafernormale und die Flächennormale der Flats stehen in der Regel senkrecht aufeinander. Konventionelle Herstellungsprozesse von Wafern mit Flats beinhalten das Erzeugen der Flats mittels Schleifen. Die Orientierungsgenauigkeit des Orientierungsflats bezüglich der kristallographischen <110> -Richtung beträgt bei konventioneller Waferherstellung $\pm$ 1 ˚, für das Identifikationsflat $\pm$ 5˚, jedoch sind auf diese Weise auch bis $\pm 0.02$˚ für das Orientierungsflat erreichbar. Durch Schleifen hergestellte Flats können längs der Flats flukturierende Desorientierungen sowie Ausbrüche aufweisen, die ihre Funktion als Referenz für die Justage von Belichtungsmasken beeinträchtigen. Das gilt vor allem für die Herstellung von Laserdioden, für die hochpräzise und darüber hinaus störungsfreie, kantenscharfe Flats mit einer Orientierungsgenauigkeit von $\leq |0.02$˚$|$ gemessen über eine für diese Technologie relevante Länge gefordert werden.

Es ist bekannt, dass die Orientierungsgenauigkeit der Flats erhöht werden kann, wenn sie statt durch Schleifen durch ein Spalten der in der Regel spröden Halbleitermaterialien unter Verwendung der natürlichen Spaltebenen erzeugt werden. Z.B. sind bei III-V-Halbleitern die {110}-Flächen natürliche Spaltflächen. Aus der US 5,279, 077 und der US 5,439,723 sind Wafer mit derartigen durch Anspalten erzeugten Flats bekannt. Aus der US 5,154,333 ist eine Vorrichtung bekannt, mit der die Spaltung über eine definierte Biegebeanspruchung eines Wafers, in dem ein durch Ritzen erzeugter Risskeim besteht, vorgenommen wird. Ein Nachteil einer mechanischen Spaltvorrichtung besteht jedoch darin, dass die Rissausbreitung nicht kontrolliert werden kann und durch die Initialisierung des Bruches durch einen Bruchkeim am Waferrand ein komplexer Bruchmodus realisiert wird.

Alternativ gibt es thermische Trennverfahren, die mit einer Kombination von lokaler Erwärmung und benachbarter lokaler Kühlung arbeiten. Ein grundlegendes Verfahren ist das in DE 28 13 302 beschriebene Verfahren zum Schneiden von Flachglas mit Hilfe von thermisch induzierten Spannungen. Bei diesem Verfahren wird Glas auf mindestens einer der beiden Hauptoberflächen innerhalb zweier auf der vorgesehenen geraden Schnittlinie hintereinander angeordneter, scharf abgegrenzter und zur Schnittlinie symmetrischer Bereiche in einem Bereich erwärmt und im anderen Bereich abgekühlt. Die über die Glasdicke und in Richtung der Schnittlinie resultierenden Temperaturgrädienten im Glas rufen Wärmespannungen hervor, die einen Riss, ausgehend vom Kantenanriss, senkrecht zu den Hauptoberflächen entlang der vorgesehenen gerade Schnittlinie treiben, wobei die Rissausbreitungsgeschwindigkeit durch Regelung der aufgebrachten Temperaturen und des Vorschubes der Heiz-/Kühlvorrichtung kontrolliert wird.

Aus WO 93/20015 ist ein Verfahren zum Trennen von Halbleiterbauelementen bekannt. Bei diesem wird durch die Bildung von Zugspannungen in einem Gebiet zwischen einem erwärmenden Laserstrahl und einer nachfolgenden Kühlung ein Bruch initiiert. Mit dem Verfahren soll die Form, die Richtung, die Tiefe und die Geschwindigkeit sowie die Genauigkeit des durch thermische Spannungen erzeugten Bruches kontrolliert werden.

Aus BELSINGER H E JR ET AL: "A fracture criterion for gallium arsenide wafers", ENGINEERING FRACTURE MECHANICS UK, Bd. 48, Nr. 2, Mai 1994 (1994-05), Seiten 199-205, XP002518266, ISSN: 0013-7944 ist ein Verfahren zum Trennen von Halbleiterbauelementen bekannt, wobei Bedingungen für das Trennen von GaAs Wafern offenbart sind.

Ein Merkmal der bekannten Verfahren zum Trennen von spröden Werkstoffen durch Rissausbreitung ist die Erzeugung oder das Vorhandensein eines Initialrisses. In der Umgebung der Rissspitze wird nun mit einer geeigneten Methode ein, wie z.B. der oben erwähnte mechanische Biegebeanspruchung oder mit thermischer Beaufschlagung ein Spannungsfeld erzeugt. Dieses Spannungsfeld führt zu einer komplexen Beanspruchung an der Rissfront, die durch den Spannungsintensitätsfaktor K gekennzeichnet wird. Wird das Spannungsfeld so gewählt, das gilt

$$K > K_C, \qquad\qquad\qquad (1.1)$$

wobei $K_C$ der materialspezifische Spannungsintensitätsfaktor ist, so wächst die Risslänge so lange, bis die Bedingung

$$K \leq K_C \qquad\qquad (1.2)$$

erfüllt ist. K > $K_C$ ist die Fortschreitbedingung für den Trennprozeß, die kontinuierlich oder in Intervallen aufrechterhalten werden muß, bis die vollständige Trennung erreicht ist.

Die Rissausbreitung verläuft nach dem Prinzip der Minimierung der freien Energie des zu trennenden Körpers. Das bedeutet, dass der Riss sich derart ausbreitet, dass in isotropen Werkstoffen die mechanische Energiefreisetzungsrate G maximal ist. In anisotropen Werkstoffen konkurriert bei der Minimierung der Gesamtenergie des Systems während der Rissausbreitung das Prinzip der Minimierung der effektiven Oberflächenenergie $2\gamma_e$ der getrennten Flächen mit dem Prinzip der Maximierung der mechanischen Energiefreisetzungsrate.

$$\frac{dU}{dC} = 2\gamma_e - G \longrightarrow Min \qquad\qquad (1.3)$$

wobei U die Gesamtenergie des Systems und C die durch Rissausbreitung erzeugte Fläche ist.

Für die oben genannten Verfahren bedeutet das, dass bei isotropen Werkstoffen die zeit- und ortsabhängigen Spannungsfelder den Verlauf des Risses kontrollieren. Beim Vorhandensein von kristallographischen Spaltebenen, die sich durch minimale effektive Oberflächenenergie auszeichnen, konkurrieren beim Rissfortschritt die durch die Spannungsfelder erzwungene Rissausbreitungsrichtung (G → max) mit den Richtungen dieser kristallographischen Spaltebenen, die eine minimale effektive Oberflächenenergie aufweisen. Deshalb gelingt es in der Praxis mit den genannten Verfahren nur Spaltebenen herzustellen, die Stufen und Sprünge in die benachbarten Netzebenen aufweisen. Dies wirkt sich nachteilig auf technologisch relevante Spaltflächen, wie Resonatorflächen von Laserbauelementen und Orientierungsabweichungen gespaltener Flats aus.

Die Herstellung absolut ebener Spaltflächen würde theoretisch dann gelingen, wenn ein ebenes Zugspannungsfeld senkrecht zur gewünschten Spaltebene erzeugt wird. In diesem Fall wären die Spannungsfelder und die Spaltebenen so aufeinander abgestimmt, dass sie nicht miteinander konkurrieren. Diese Bedingungen sind in der Praxis nicht einzuhalten. Es würde zum Beispiel für das Spalten von Laserbauelementen erfordern, dass der Wafer hochpräzise zur Spaltvorrichtung orientiert werden muß, um zumindest über die Länge eines Laserbauelements hinreichende Qualität der Spaltebene zu erreichen. Selbst bei kleinsten Abweichungen der Waferorientierung bezüglich der erzeugten Spannungsfelder sind Stufen auf der Spaltebene unvermeidbar.

Es ist Aufgabe der Erfindung, ein Verfahren zum Trennen von Einkristallen bereitzustellen, welches die oben genannten Nachteile vermeidet und exakte Spaltebenen über die gesamte Distanz bis zum völligen Abtrennen der gewünschten Teile sichert.

Die Aufgabe wird gelöst durch ein Verfahren nach Patentanspruch 1. Weiterbildungen der Erfindung sind in den Unteransprüchen angegeben.

Das Verfahren weist den Vorteil auf, dass die vorherige Bestimmung und Justierung der kristallographischen Spaltebenen zur Spaltvorrichtung lediglich mit praxisüblichen Genauigkeiten erforderlich ist. Die exakte Orientierung des sich ausbreitenden Risses wird durch die erfindungsgemäßen Prozeßbedingungen gesichert, die eine Selbstjustierung der Rissausbreitungsrichtung in genau einer der kristallographischen Spaltebenen ohne Stufen und Sprünge erzwingen.

Aufgrund der Erfindung sind Spaltflächen mit Genauigkeiten im Bereich von $\leq$ [0,02˚], |0,01˚|, |0,005˚| oder sogar |0,001˚|- gemessen über die Ausdehnung der jeweils technologisch relevanten Fläche oder einer Vielzahl von Teilflächen davon - erzielbar. Die jeweils technologisch relevante Fläche entspricht im Fall von Laserdioden beispielsweise der Länge eines Laserresonators oder im Fall von integrierten Schaltkreisen der Randlänge des abzutrennenden Chips. Beim Abspalten vom Wafer zur Bildung von Flats entspricht sie der Flatlänge. Auch die Herstellung einer natürlichen Spaltfläche ist aufgrund der hier vorgeschlagenen selbstadjustierten Spaltung möglich.

Die Orientierungsgenauigkeit einer Trennfläche bezüglich einer kristallographischen Netzebene wird gemessen durch Anlegen des Kristalls an eine Referenzfläche, wobei mindestens 2 Punkte der Trennfläche zum Anschlag kommen. Mit einem Röntgengoniometer kann dann die Orientierung der kristallografischen Netzebene bezüglich dieser Referenzfläche bestimmt werden. Die Netzebenenausrichtung wird nun zur Referenzanschlagfläche in Beziehung gesetzt, woraus sich eine Winkeldifferenz ergibt, welcher hier die Genauigkeit repräsentiert.

Die Ausrichtung der Trennfläche bezüglich der Referenzfläche des zur Bestimmung der Netzebenenausrichtung verwendeten Verfahrens kann außer durch mechanischen Anschlag auch auf anderem Wege z. B. durch optische Verfahren erfolgen.

Neben der Bestimmung der globalen Orientierungsabweichung der verfahrensgemäß hergestellten Spaltfläche technologisch relevanter Länge kann auch eine lokale Orientierungsabweichung ermittelt werden, indem die technologisch relevante Länge in Teillängen von z. B. 2 mm unterteilt wird und deren Ausrichtung z. B. mittels eines optischen Mikroskops, eines Miniaturinterferometers, eines Weißlichtinterferometers oder eines Autokollimators erfolgt. Die Orientierungsgenauigkeit der Trennfläche entspricht dann der größten dieser gemessenen lokalen Abweichungen.

Die durch die Erfindung erzielten Spaltflächen sind durch bekannte Messverfahren z. B. durch das LEED-Verfahren als solche von Oberflächen einer Halbleiterscheibe mit anderer Orientierung unterscheidbar. , vgl. hierzu Qian, G.X., Martin, R.M., Chadi, D.J., in Phys. Rev. B, Vol. 37, p.1303. (1988) oder Bechstedt, F. "Principles of Surface Physics", Springer Verlag; ISBN 978-3-540-00635-0, Kapitel 1.2.4; Seiten 16-18. Ausgenutzt wird, dass natürliche Spaltflächen von III-V-Halbleitern lediglich eine relaxierte, jedoch keine rekonstruierte Anordnung der oberflächennahen Atome zeigen, wie das für andere Orientierungen der Fall ist..

Weitere Vorteile und Zweckmäßigkeiten ergeben sich aus der Beschreibung eines Ausführungsbeispieles anhand der Figuren. Von den Figuren zeigen:

Fig. 1     eine schematische Draufsicht auf einen zu spaltenden Wafer;

Fig. 2     die Energiefreisetzungsrate G und effektive Oberflächenenergie $2\gamma_e$ bei Einhaltung einer ersten Bedingung;

Fig. 3     die Energiefreisetzungsrate G und effektive Oberflächenenergie $2\gamma_e$ bei Einhaltung einer zweiten Bedingung;

Fig. 4     die Energiefreisetzungsrate G und effektive Oberflächenenergie $2\gamma_e$ bei Einhaltung einer dritten Bedingung;

Fig. 5     die Energiefreisetzungsrate G und effektive Oberflächenenergie $2\gamma_e$ bei Einhaltung seiner vierten Bedingung;

Fig. 6     eine erste Phase der Rissausbreitung;

Fig. 7     eine zweite Phase der Rissausbreitung, die durch die Relativbewegung der Spannungsfelder kontrolliert wird (z. B. in isotropen Werkstoffen);

Fig. 8     eine Phase der Rissausbreitung im Fall der Abweichung von der gewünschten Spaltrichtung bei Vorhandensein einer kristallographischen Spaltebene und unsymmetrischer Justierung der Spannungsfelder zu dieser;

Fig. 9     eine Phase der Rissausbreitung in der gewünschten Spaltrichtung bei ideal symmetrischer Justierung der Spannungsfelder zur Spaltebene;

Fig. 10     eine schematische Darstellung der Orientierung des Wafers in der Spaltvorrichtung;

Fig. 11     ein Beispiel für den Maximalfehler zwischen Position und Richtung der gewünschten Spaltebene zur Bewegungsrichtung und den erzeugten Spannungsfeldern im Startgebiet;

Fig. 12     ein Beispiel für den Maximalfehler zwischen Position und Richtung der gewünschten Spaltebene zur Bewegungsrichtung und den erzeugten Spannungsfeldern im Zielgebiet;

Fig. 13     die Energiefreisetzungsrate $G_-$ und $G_+$ im Start- bzw. im Zielgebiet in Abhängigkeit vom Winkel $\alpha$; und

Fig. 14     eine Phase der Rissausbreitung unter Einhaltung der erfindungsgemäßen Bedingungen.

Nachfolgend wird die Erfindung anhand des Ausführungsbeispiels des Spaltens eines GaAs-Wafers mittels thermisch induzierten Spannungsfeldern beschrieben. Zunächst wird der Wafer in eine Spaltvorrichtung eingebracht. Die Ausrichtung des Wafers zur Spaltvorrichtung erfolgt an einer vorher angebrachten Markierung, z.B. einem kurzen Flat, welches z.B. mit Hilfe von Röntgendiffraktometrie gerichtet angeschliffen wird. Dabei ist in der Praxis eine Genauigkeit der Flatausrichtung zur {110}-Spalteben von 0,1˚ erreichbar. Auch andere Markierungen oder kurze Flats senkrecht oder in einem bestimmten Bezug zu den Spaltebenen sind als Vorjustierungshilfe denkbar. Die Vorjustierung zur Bewegungsrichtung kann mit Hilfe von Anschlägen oder mit optischen Methoden erfolgen.

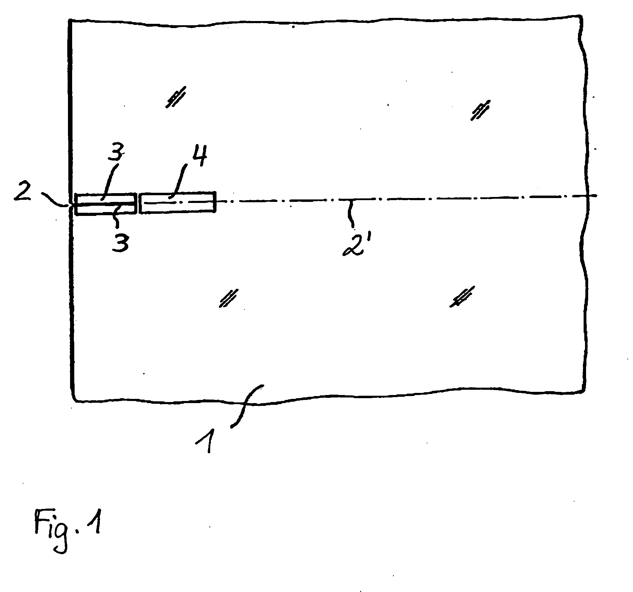

Wie schematisch aus Fig. 1 ersichtlich ist, wird in den GaAs-Wafer 1 ein Initialriss 2 in einer {110}-Spaltebene eingebracht. Idealerweise wird der Initialriss 2 in eine Spaltebene eingebracht, die parallel zu der bevorzugten Gleitrichtung der $\alpha$-Versetzungen verläuft.

Der Initialriss 2 wird beispielsweise durch Eindruck mittels eines Indenters mit definierter Geometrie erzeugt (Vickers, Knoop-Indenter). Auch andere Geometrien oder ein Anritzen ist möglich. Durch Wahl der Eindrucklast und -geometrie kann die Ausbildung von senkrecht dazu gerichteten B-Rissen vermieden werden.

Durch thermisch induzierte Spannungsfelder wird aus dem eindruckinduzierten Riss ein ebener bis zur Waferrückseite durchgehender Randriss in der {110}-Spaltebene erzeugt, der als ebener Initialriss für die weitere Rissausbreitung bzw. die gewünschte Spaltrichtung bzw. Spaltebene 2' dient. Die thermisch induzierten Spannungsfelder werden in dieser Phase so dimensioniert, dass der Initialriss sich noch nicht weiter ausbreiten kann.

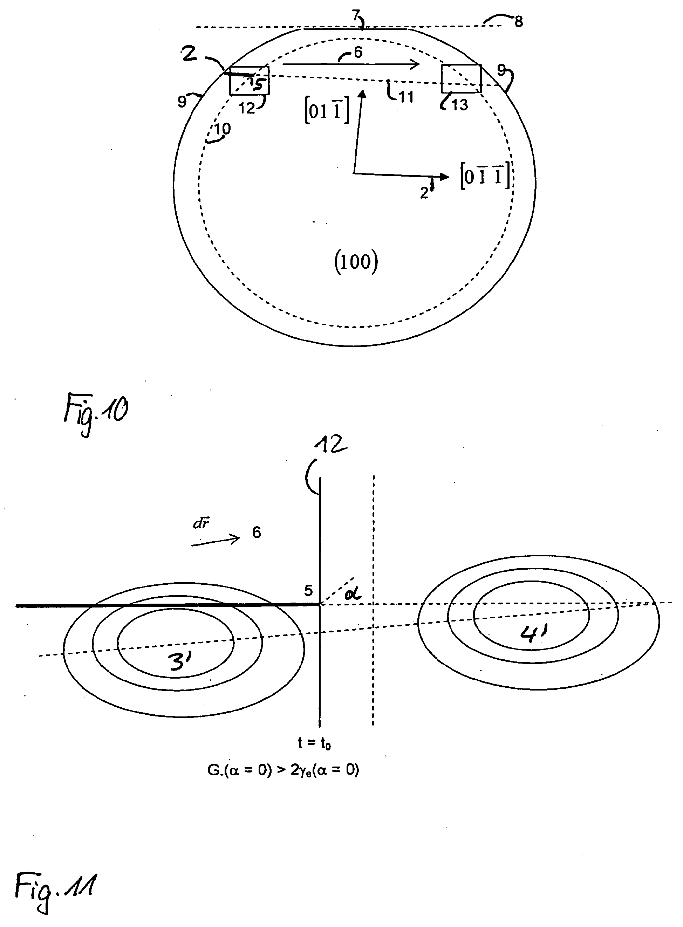

Dann wird zur Rissausbreitung eine Spannungsintensität K erzeugt und die Größe G($\alpha$) bestimmt, die die Energiefreisetzungsrate bei weiterer Rissausbreitung in Abhängigkeit von einer Ablenkung des Risses von der Spaltebene um den Winkel $\alpha$ ist. Die Rissausbreitung kann als Überlagerung einer Verwindung (twist- configuration) um den Winkel $\phi$ um eine Achse senkrecht zur Rissfront des Initialrisses und einer Drehung um den Winkel $\theta$ um die Rissfront des Initialrisses (tilt-configuration) betrachtet werden. Beide Fälle können getrennt betrachtet werden. Das beschriebene erfindungsgemäße Verfahren gilt für beide Fälle, sodass im weiteren der Bezug auf einen Ablenkwinkel $\alpha$ genügt (mit $\alpha = \theta$ für tilt- und $\alpha = \phi$ für twist configuration). Das Ausführungsbeispiel ist am Beispiel der tilt- configuration erläutert ohne die Gültigkeit für den allgemeinen Fall einzuschränken. Die Spannungsintensität K wird unter Nutzung bekannter Verfahren, wie beispielsweise das Verfahren gemäß der DE 28 13 302 oder das Verfahren der WO 93/20015 erzeugt. Dabei wird eine oder mehrere Wärmequellen 4 sowie eine oder mehrere Wärmesenken 3 (vgl. Fig. 11, 12, 14) auf eine oder beide Waferseiten aufgebracht, sodass idealerweise bezüglich der Waferdicke sowie zur gewünschten Spaltrichtung symmetrische Spannungsfelder vorliegen. Die Wärmequellen können z. B. durch Absorption von Laserstrahlen und die Wärmesenken durch gezielte Aufbringung von Kühlaerosolen erzeugt werden, wie dies beispielsweise in der WO 93/20015 beschrieben ist. Aber auch andere Varianten sind möglich. Die Wärmequellen und Senken werden so gesteuert und positioniert, dass ein Rissfortschritt ermöglicht wird.

Die Dimensionierung beziehungsweise Steuerung - oder auch eine Regelung - der Spannungsfelder erfolgt derart, dass kontinuierlich oder intervallweise ein Rissfortschritt erfolgt, der durch G $(0) \geq 2\ \gamma_e(0)$ gekennzeichnet ist. Erfindungsgemäß erfolgt die Dimensionierung bzw. Steuerung der Spannungsfelder ferner derart, dass zusätzlich mindestens eine der folgenden Bedingungen:

$$\left|\frac{\partial G}{\partial \alpha}\right|_{\alpha=0} \leq 2\frac{\beta_e}{h} \text{ wenn } \frac{\partial^2 G}{\partial \alpha^2} \leq 0 \qquad\qquad (2.1)$$

oder

$$\left|\frac{\partial G}{\partial \alpha}\right| \leq 2\frac{\beta_e}{h} \qquad\qquad \forall \alpha : \alpha_1 < \alpha < \alpha_2 \qquad\qquad (2.2)$$

erfüllt sind.

Es sind

$\alpha$      möglicher Ablenkwinkel bei Rissfortschritt von der Spaltebene

$\alpha_1, \alpha_2$      Winkelbereich, in dem die notwendige Bedingung für Rissausbreitung (1.1) gewährleistet ist

$G(\alpha)$      Energiefreisetzungsrate in Abhängigkeit von einer Ablenkung des Risses von der Spaltebene um den Winkel $\alpha$.

$\gamma_e(0)$      effektive Oberflächenenergie der Spaltfläche

$\gamma_e$      richtungsabhängige effektive Oberflächenenergie

$\beta_e$      effektive Stufenenergie (materialspezifisch)

h      Stufenhöhe (materialspezifisch).

Die effektive freie Oberflächenenergie $\gamma_e$, die aus der Bruchmechanik bekannt ist, wird in Bruchexperimenten aus dem Zusammenhang zwischen Bruchfestigkeit und Risslänge bestimmt. Sie enthält im Vergleich zur intrinsischen Oberflächenenergie $\gamma_s$ auch noch Energieanteile dissipativer Prozesse. Dazu gehören beispielsweise die Bildung von Versetzungen in der Prozeß- bzw. plastischen Zone, die Emission von Schallenergie oder das Auftreten von dissipativen Strukturen (Bruchstrukturen) auf den Bruchflächen. Sie ist somit größer als die intrinsische Oberflächenenergie $\gamma_s$.

Für die spezifische freie Stufenenergie findet man im thermodynamischen Gleichgewicht die folgende Näherungsbeziehung:

$$\beta_e = -nk_B T \ln \eta (1 + 2\eta), \quad \eta = \exp(-\varepsilon / k_B T).$$

In ihr bedeuten: n - Stufendichte mit n = 1/a, $k_B$ - Boltzmann-Konstante, $\varepsilon$ - Bindungsenergie zwischen nächsten Nachbarn im Kristallgitter, a - Abstand der Bausteine in der Stufe.

Die Bindungsenergie $\varepsilon$ kann aus der Sublimationsenergie $\Delta H_{sub}(T)$ des Kristalles ("kongruente Verdampfung") und der Koordinationszahl Z des betrachteten Kristalles abgeschätzt werden:

$$\varepsilon \approx \Delta H_{sub} / Z,$$

$\Delta H_{sub}(T)$ gewinnt man aus einer Berechnung des thermodynamischen Gleichgewicht $X_s \Leftrightarrow X_g$ mit den thermodynamischen Daten der festen (s) und gasförmigen (g) Phase X.

Die freie Stufenenergie kann auch experimentell bestimmt werden.

Für GaAs können folgende Werte angenommen werden:

Die effektive freie Oberflächenenergie von GaAs {110}- Spaltflächen ergibt sich aus Bruchexperimenten zu $\gamma_e$ (0) $\approx$ (0.86 $\pm$ 0.15) J/m$^2$. Durch bekannte Untersuchungen im Bereich der Rissfront wurde gesichert, dass dissipativer Vorgänge vernachlässigt werden können, die gemessene effektive freie Oberflächenenergie also der intrinsischen Oberflächenenergie $\gamma_s(0) \approx$ 0.82 J/m$^2$, die sich aus Kristallzüchtung ergibt, nahekommt.

Für GaAs {110}/<001>, d. h. <001> orientierte Stufen auf einer {110} Spaltfläche mit Kippachse parallel zu <001> wurde die Stufenenergie mit folgenden Daten abgeschätzt: $\Delta H_{sub}(300$ K) = 451,4 kJ/mol, Z = 4 $\Rightarrow \varepsilon \approx$ 1.17 eV und für T = 300 K $\eta \approx$ 45.25.

Der Abstand der Atome in einer <001> parallelen Stufe beträgt $a_o$ = 0.565325 nm, die Höhe einer Doppelstufe ist h = $a_o/\sqrt{2}$ = 0.399 nm. Damit ergibt sich aus der obigen Formel die freie Stufenenergie zu:

$$\beta_e \approx 3{,}31 \times 10^{-10} \text{ J/m}$$

und

$$\beta_e/h \approx 0.83 \text{ J/m}^2$$

Dieser Wert stimmt etwa mit der intrinsischen freien Oberflächenenergie $\gamma_s \approx$ 0.82 J/m$^2$ einer {110} Spaltfläche überein.

Für die freie Stufenenergie gilt sinngemäß die gleiche Aussage wie für die Oberflächenenergie. Die experimentelle effektive Stufenenergie kann aufgrund dissipativer Anteile größer sein als die hier abgeschätzte. Mit der Angabe der theoretisch ermittelten Stufenergie ist die rechte Seite in den Bedingungen (2.1) und (2.2) bekannt,

Durch Simulationsrechnungen werden die Spannungsfelder unter den gewählten Bedingungen der Wärmequellen und -senken berechnet. Aber auch die direkte Messung der Spannungen ist möglich, z.B. durch Spannungsdoppelbrechung, Ultraschallmikroskopie oder Mikro-Ramanspektroskopie. Daraus wird für das vorgegebene Spannungsfeld die Energiefreisetzungsrate in Abhängigkeit von möglichen Ablenkungen des Risses um den Winkel $\alpha$ berechnet. Durch Steuerung und Positionierung der Wärmequellen und -senken werden die Spannungsfelder so eingestellt, dass die oben genannten erfindungsgemäßen Bedingungen erfüllt sind.

Dabei existiert ein Winkelbereich $\alpha_1 < \alpha < \alpha_2$, in dem die Bedingung $G \geq 2\gamma_e$ erfüllt ist. Dieser Bereich hängt von den Spannungsfeldern und den Materialeigenschaften sowie der Dejustierung der verwendeten Spaltvorrichtung von der zu trennenden Spaltebene ab. Im Winkelbereich zwischen $\alpha_1$ und $\alpha_2$ ist die notwendige Bedingung (1.1) für eine Rissausbreitung erfüllt. Die erfindungsgemäße Steuerung bzw. Dimensionierung der Spannungsintensität K auf die Einhaltung der Bedingung (2.1) oder (2.2) sichert, dass dennoch der Riss nicht im Bereich $\alpha_1 < \alpha < \alpha_2$ abgelenkt wird, sondern über die gesamte zu trennende Distanz in der gewünschten Spaltebene verläuft.

Die unvermeidbare Dejustierung der Spaltvorrichtung, bzw. eine Spannungsintensität K mit gemischten Rissöffnungsmoden $K_I + K_{II} + K_{III}$, erzeugt eine zur gewünschten Rissausbreitungsrichtung in der Spaltebene $\alpha$ = 0 unsymmetrischen Verlauf der Energiefreisetzungsrate G($\alpha$) in Abhängigkeit von möglichen Ablenkwinkeln $\alpha$. Ferner breitet sich der Riss in die Richtung aus, bei der die Größe $g = G - 2\gamma_e$ maximal wird. Die erfindungsgemäße Steuerung bzw.

Dimensionierung der Spannungsintensität K auf die Einhaltung der Bedingungen (2.1) oder (2.2) sichert, dass auch bei Dejustierung der Spaltvorrichtung, bzw. ein Spannungsintensität K mit gemischten Rissöffnungsmoden $K_I + K_{II} + K_{III}$ das Maximum der Größe g immer bei $\alpha = 0$ liegt. Dadurch wird der Rissfortschritt in der gewünschten Netzebene durch eine Selbstjustierung der Rissausbreitungsrichtung erzwungen. Dadurch lassen sich kristallografische Spaltflächen mit hoher Orientierungsgenauigkeit im Bereich von mindestens $\leq |0,01°|$, $\leq |0,005°|$ oder sogar $\leq |0,001°|$ erzeugen. Weiterhin lassen sich kristallografische Spaltflächen mit einer minimalen Stufendichte, idealerweise ohne Stufen, über die gesamte technologisch relevante Fläche (Flats, Resonatorflächen o.ä.) erzeugen.

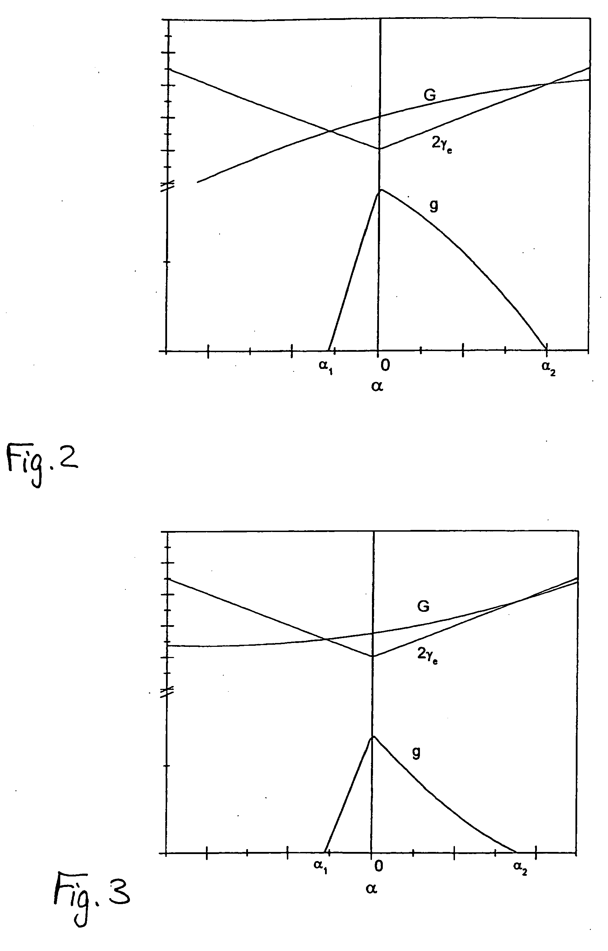

Zwei Situationen bei denen die erfindungsgemäßen Bedingungen eingehalten sind, sind in Fig. 2 und Fig. 3 dargestellt.

Fig. 2 zeigt die Energiefreisetzungsrate G und effektive Oberflächenenergie $2\gamma_e$ sowie g = G - $2\gamma_e$ bei Einhaltung der Bedingung $\left| \dfrac{\partial G}{\partial \alpha} \right|_{\alpha=0} \leq 2 \dfrac{\beta_e}{h}$ und $\dfrac{\partial^2 G}{\partial \alpha^2} \leq 0 \ \forall \alpha : \alpha_1 < \alpha < \alpha_2$.

Fig. 3 zeigt die Energiefreisetzungsrate G und effektive Oberflächenenergie $2\gamma_e$ sowie g = G - $2\gamma_e$ bei Einhaltung der Bedingung $\left| \dfrac{\partial G}{\partial \alpha} \right| \leq 2 \dfrac{\beta_e}{h} \ \ \forall \alpha : \alpha_1 < \alpha < \alpha_2$.

Mit dem Verfahren können am Wafer Flächen, wie zum Beispiel Flats mit einer Orientierungsgenauigkeit von $0,01°$ - gemessen über Längen der jeweils technologisch relevanten Flächen - angebracht werden, d.h. die Genauigkeit, die in der Praxis durch einen Schleifprozeß erreicht werden kann, wird um eine Größenordnung erhöht. Das Verfahren sichert, dass die Justiergenauigkeit zwischen Bewegungsrichtung und Spaltebene von $0,1°$ ausreicht, um die Rissausbreitung in der Spaltebene mit einer Genauigkeit von $\leq 0,01°$ zu erzwingen. Erste Resultate zeigen, dass Genauigkeiten von $\leq 0,005°$ oder sogar $\leq 0,001°$ möglich sind. Schließlich ist auch die vollständig stufenfreie, ideale Spaltfläche möglich, die sich dann entlang der natürlichen kristallographischen Ebene erstreckt.

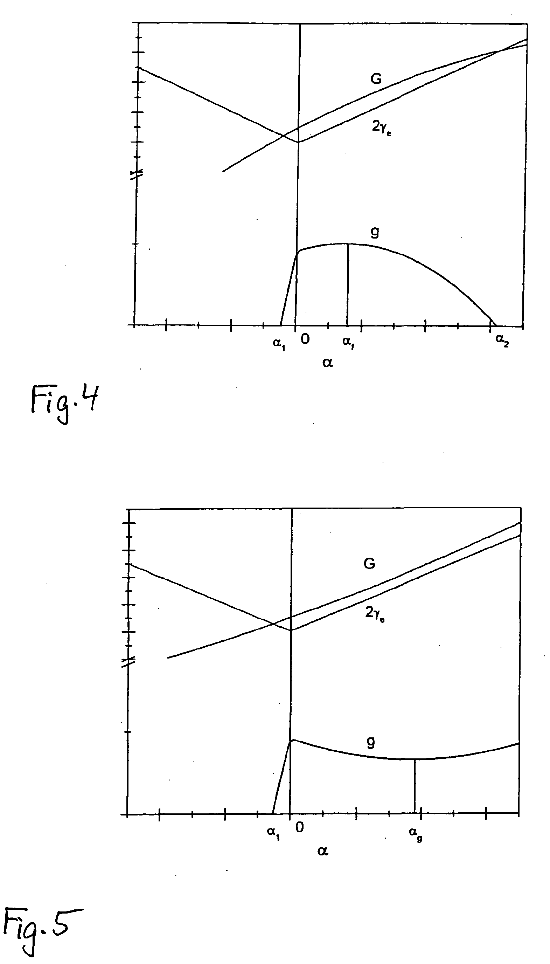

Fig. 4 und Fig. 5 zeigen Situationen, bei der eine Dejustierung der Spaltvorrichtung, bzw. eine Spannungsintensität K mit gemischten Rissöffnungsmoden vorliegt und die erfmdungsgemäßen Bedingungen nicht eingehalten werden.

Fig. 4 zeigt die Energiefreisetzungsrate G und effektive Oberflächenenergie $2\gamma_e$ sowie g = G - $2\gamma_e$ mit $\left| \dfrac{\partial G}{\partial \alpha} \right|_{\alpha=0} > 2 \dfrac{\beta_e}{h}$. In Fig. 4 erfolgt die Rissausbreitung bei $\alpha = \alpha_f$ d.h. der Riss weicht von der gewünschten Spaltrichtung $\alpha = 0$ ab. Es entstehen auf der erzeugten Fläche Stufen oder gekrümmte Flächen. Die technologisch relevanten Flächen (Flats, Resonatorflächen) besitzen nicht die gewünschte Orientierungsgenauigkeit oder Qualität.

Fig. 5 zeigt die Energiefreisetzungsrate G und effektive Oberflächenenergie $2\gamma_e$ sowie g = G - $2\gamma_e$ mit $\left| \dfrac{\partial G}{\partial \alpha} \right| > 2 \dfrac{\beta_e}{h}$ für $\alpha > \alpha_g$. In Fig. 5 ist der Rissverlauf bei $\alpha = 0$ nicht stabil. Bei einer Überschreitung des Winkels $\alpha \geq \alpha_g$ erfolgt eine Abweichung des Rissverlaufes von der gewünschten Ebene $\alpha = 0$.

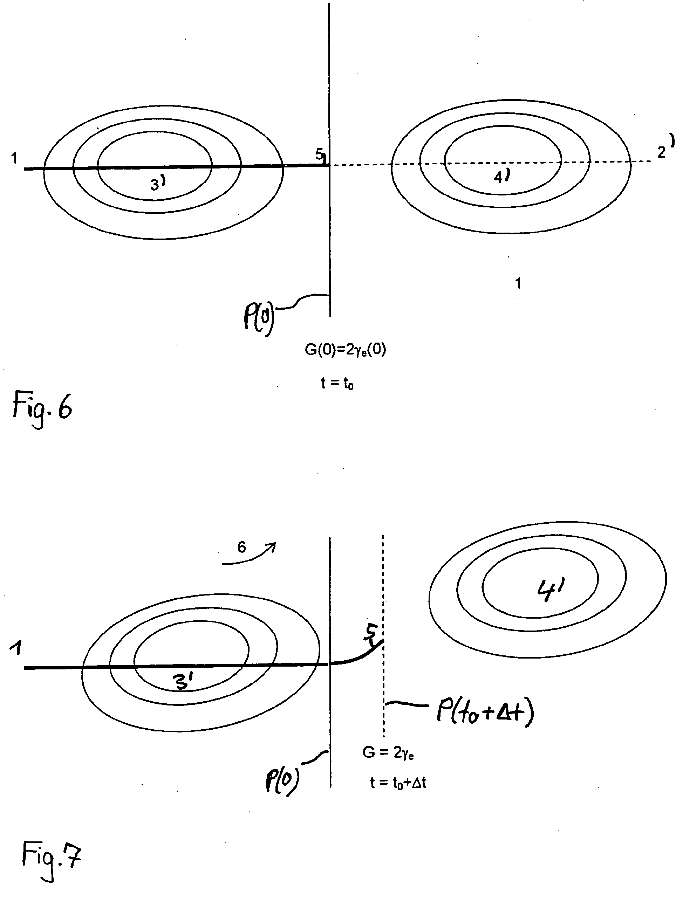

Die Figuren 6 bis 9 zeigen verschiedene Fälle der Rissausbreitung im Wafer. Durch Steuerung und Positionierung der Wärmequellen und Wärmesenken wird ein Druckspannungsmaximum 4' und ein Zugspannungsmaximum 3' erzeugt. Die Wärmequellen und -senken werden so positioniert, dass das Druckspannungsmaximum 4' vor der Rissspitze 5 in Ausbreitungsrichtung und das Zugspannungsmaximum 3' hinter der Rissspitze 5 positioniert wird, wie in Fig. 6 gezeigt ist. Im Bereich zwischen Zug- und Druckspannungsmaxima ist zum Zeitpunkt t = $t_0$ an einer bestimmten Position P(0) die Bedingung $K = K_c$ bzw. $G = 2\gamma_e$ erfüllt. Durch Relativbewegung zwischen Temperaturfeldern und Wafer, die in Fig. 7 durch den Pfeil 6 angedeutet ist, können die Bedingungen (1.1) $K > K_c$ bzw. $G > 2\gamma_e$ oder (1.2) $K \leq K_C$ bzw. $G \leq 2\gamma_e$ kontrolliert werden, d.h. die Rissspitze 5 kann geführt, gezielt gestoppt oder weiterbewegt werden. Die Relativbewegung kann durch die Bewegung der Wärmequellen und Senken (Laserfokus und Kühldüsen) oder aber auch durch eine Bewegung des Wafers oder eine Kombination aus beiden erfolgen. Dissipative oder dynamische Effekte können durch die Kontrolle der Ausbreitungsgeschwindigkeit vermieden werden. Die Ausbreitungsgeschwindigkeit kann hinreichend klein gewählt werden, dass quasistatische Rissausbreitung und thermodynamisches Gleichgewicht vorausgesetzt werden können (v «1/3 der Schallgeschwindigkeit). Der Rissverlauf folgt der Relativbewegung 6 zwischen den Spannungsfeldern und dem Wafer 1. Dies wird im Stand der Technik genutzt, um auch komplizierte Geometrien zu schneiden, die geradlinig oder krummlinig sein können.

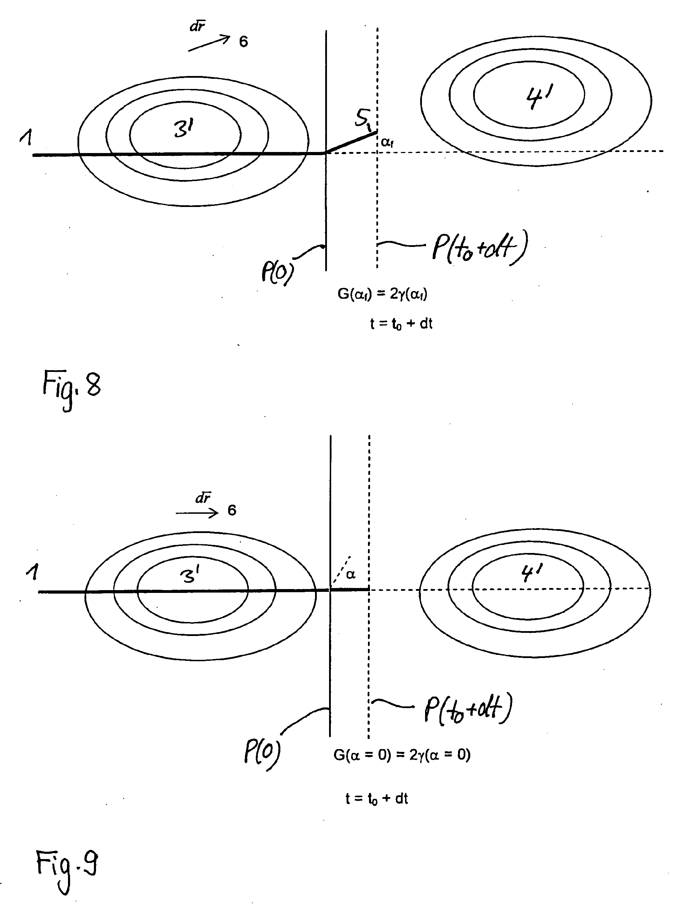

Bei der Anwesenheit von kristallografischen Spaltebenen konkurrieren während der Relativbewegung 6 zwischen den Spannungsfeldern und dem Wafer, wie oben beschrieben, der Einfluss der Spaltebenen mit dem der Spannungsfelder 3' und 4' bzw. die Spaltrichtung 2' mit der Bewegungsrichtung 6 der Vorrichtung während des Risswachtums miteinander. Diese Situation ist in Fig. 8 dargestellt. Bei einer infinitesimalen Relativbewegung 6 um $d\bar{r}$ wird der Riss aufgrund des Energieprinzips (1.3) im Allgemeinen um den Winkel $\alpha_f$ abgelenkt. Das entspricht der Situation in Fig. 4. Die Rissspitze befindet sich an der Position P(t$_0$+dt), wo die Bedingung $G(\alpha_f) = 2\gamma_e(\alpha_f)$ nach einer Zeit t = t$_0$+dt erreicht wird (quasistatische Rissausbreitung). Auf diese Weise werden im Allgemeinen unerwünschte Stufen auf den Spaltebenen erzeugt oder es kommt zu Abweichungen von der gewünschten Spaltrichtung.

Um die Konkurrenz zwischen Spaltrichtung und Spannungsfeldern zu vermeiden, müsste nach bekannten bruchmechanischen Prinzipien idealerweise die maximalen Zugspannungen senkrecht zur gewünschten Spaltebene gerichtet sein. Um diese Situation am besten zu erreichen, müsste eine ideal symmetrische Justierung der Spannungsfelder 4' und 3' (d.h. Wärmequelle bzw. -senke) zur Spaltebene durchgeführt werden, die auch während des gesamten Trennvorganges, d.h. über Distanzen des Durchmessers eines GaAs- Wafers, aufrechterhalten werden muss. Das heisst, dass auch die Bewegungsrichtung 6 der Vorrichtung ideal parallel zur Spaltebene 2' und sowie zur Symmetrielinie der Spannungsfelder justiert werden muss. Diese Situation ist in Fig. 9 dargestellt. Nach einer Relativbewegung um $d\bar{r}$ verbleibt die Rissspitze an der Position P(t$_0$+dt), an der die Bedingung $G(0) = 2\gamma_e(0)$ nach einer Zeit t = t$_0$+dt erreicht wird. Das heißt der Riss verläuft in der Spaltebene. Diese ideale Situation ist in der Praxis jedoch nicht erreichbar. Das würde die Messung und Justierung der Spaltebene zu den Wärmequellen und -senken sowie zur Bewegungsrichtung der Vorrichtung mit sehr hoher Präzision erfordern, die unter produktionstechnischen und wirtschaftlichen Gesichtspunkten nicht erreichbar ist. Mit Hilfe der Erfindung wird dennoch eine Fläche erzeugt die mit sehr hoher Genauigkeit orientiert ist.

Fig. 10 zeigt die Orientierung des Wafers 1 in der Spaltvorrichtung. Wie oben beschrieben, ist üblicherweise eine Markierung bzw. ein kurzes Flat 7 vorhanden, welches mit einer gewissen Orientierungstoleranz zur den kristallographischen Richtungen angeschliffen wird. Dabei ist unter praktischen Bedingungen mit vertretbarem Aufwand eine Genauigkeit der Flatausrichtung 8 zu den {110}- Spaltebenen von 0,1 erreichbar. Das Flat 7 ist zur Bewegungsrichtung 6 der Relativbewegung zwischen Spannungsfeldern und Wafer vorjustiert. Mit dem erfindungsgemäßen Trennverfahren wird am Wafer eine Fläche (Flat) mit einer Orientierungsgenauigkeit von ≤ |0,01˚| angebracht, d.h. die Genauigkeit, die in der Praxis durch einen Schleifprozess erreicht werden kann, um eine Größenordnung erhöht. Das erfindungsgemäße Verfahren sichert, dass die Justiergenauigkeit zwischen Bewegungsrichtung 6 und Spaltebene 2' von 0,1˚ ausreicht, um die Rissausbreitung in der Spaltebene mit einer Genauigkeit von mindestens ± 0,01˚ zu erzwingen. Das kann von Waferrand 9 zu gegenüberliegenden Waferrand 9 geschehen oder es kann ein gewisser Bereich 10 existieren, innerhalb dessen die Forderung der Orientierungsgenauigkeit des zu erzeugenden Flats 11 erfüllt sein muss. Die Größe und Geometrie dieses Bereiches 10 kann variieren und hängt von verschiedenen technologischen Forderungen ab. Genauigkeiten von ≤ |0,005˚| oder sogar ≤ |0,001˚| sind auch möglich, sowie auch das exakt stufenfreie Spalten entlang der kristallographischen Ebene.

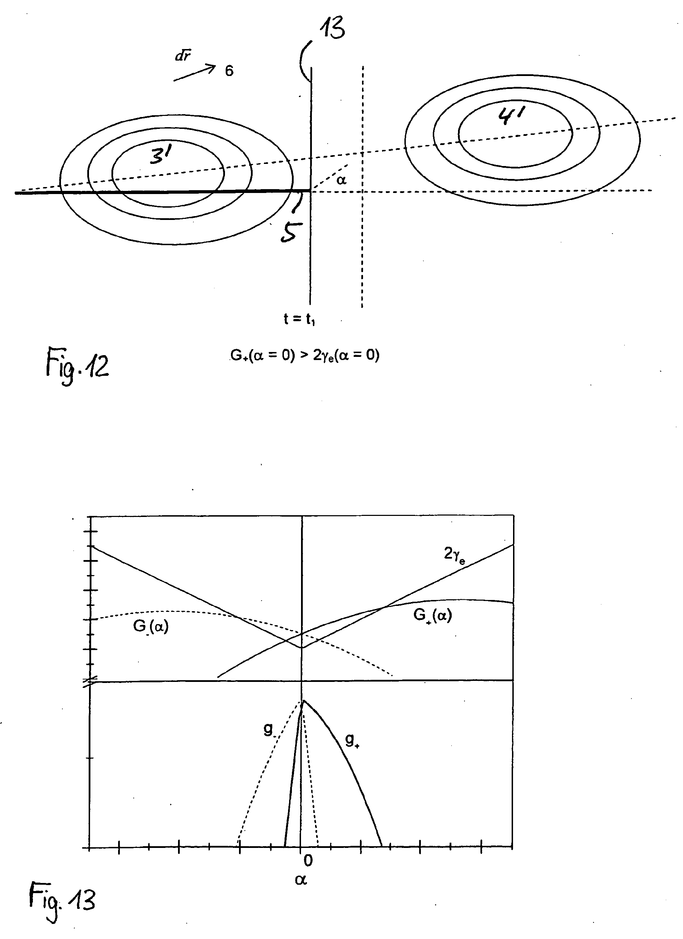

Durch Simulationsrechnungen im Vorfeld werden die Spannungsfelder vorzugsweise unter den gewählten Bedingungen der Wärmequellen und -senken berechnet. Die Simulation wird in den Gebieten am vorgesehenen Start- und Zielpunkt des Trennvorganges durchgerührt. Das kann z.B. an den Rändern des technologisch genutzten Bereiches 10 in den Gebieten 12 und 13 geschehen. Wobei der durch die oben beschriebenen Verfahren eingebrachte Initialriss 2 in der Spaltebene am Rand des Startgebietes 12 vorhanden ist, vorzugsweise außerhalb des Bereiches 10. Aber auch andere Positionen sind möglich. Die Proportionen in Fig. 10 sind nicht maßstabsgerecht und zur Veranschaulichung der Situation übertrieben dargestellt. Die bekannten vorliegenden Messgenauigkeiten (z.B. bei der Röntgendiffraktometrie), die bekannten Toleranzen beim Schleifen und die bekannten Positioniergenauigkeiten bestimmen den maximal möglichen Fehler bei der Vorjustierung des Wafers. So ist es beispielsweise mit Hilfe einfacher geometrischer Beziehungen möglich, den Maximalfehler zwischen Position und Richtung der gewünschten Spaltebene zur Bewegungsrichtung 6 und zu den erzeugten Spannungsfeldern 3' und 4' im Start- und Zielgebiet des Trennvorganges 12 und 13 zu bestimmen. Fig. 11 zeigt ein Beispiel für den Maximalfehler im Startgebiet 12. Fig. 12 zeigt ein Beispiel für den Maximalfehler im Zielbereich 13. Aber auch gespiegelte Positionen sind möglich.

Nun kann bei den gegebenen Spannungsfeldern in der Startposition 12 der Rissspitze 5 des Initialrisses die Energiefreisetzungsrate für den Fall der infinitesimalen Rissausbreitung in Abhängigkeit von möglichen Ablenkungen um den Winkel $\alpha$ berechnet werden. Das gleiche kann berechnet werden im geplanten Zielgebiet 13 unter der Annahme, dass der Riss die Spaltebene 2' nicht verlassen hat. Dadurch entstehen zwei Funktionen G$_-$($\alpha$) und G$_+$($\alpha$), die durch die bekannten Maximalfehler in der Start- und Zielpositionen gegeben sind. Die wahre Funktion G($\alpha$) ist nicht bekannt, stellt aber einen Zustand zwischen G$_-$($\alpha$) und G$_+$($\alpha$) dar.

Durch Dimensionierung und Positionierung der Wärmequellen und -senken werden nun die Spannungsfelder so eingestellt, dass die erfindungsgemäßen Bedingungen

$$\left|\frac{\partial G}{\partial \alpha}\right|_{\alpha=0} \le 2\frac{\beta_e}{h} \tag{3.1.}$$

und

$$\frac{\partial^2 G}{\partial \alpha^2} \le 0 \tag{3.2}$$

für beide Funktionen $G_-(\alpha)$ und $G_+(\alpha)$ erfüllt sind. Damit wird gewährleistet, dass für jeden Zwischenzustand $G(\alpha)$ ebenfalls die erfindungsgemäßen Bedingungen erfüllt sind und der Riss während des gesamten Trennvorganges in seiner Spaltebene verbleibt.

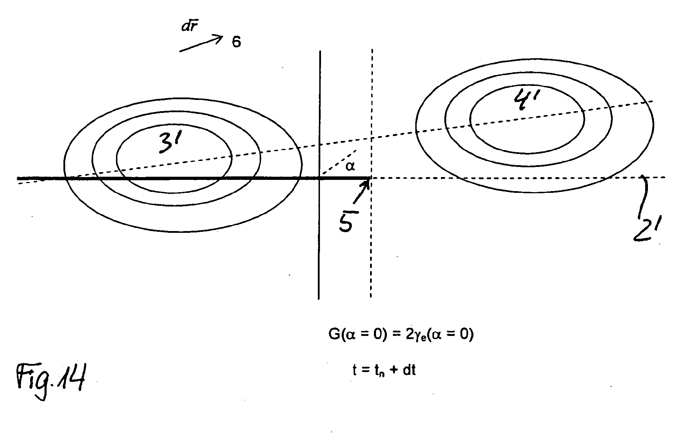

Fig. 13 zeigt ein Beispiel einer abgeglichenen Situation. Mit der Einhaltung der erfindungsgemäßen Bedingung für beide Funktionen $G_-(\alpha)$ und $G_+(\alpha)$ hat die Funktion g auch in allen möglichen (nicht bekannten) Zwischenzuständen während des Trennvorganges ihr Maximum bei $\alpha = 0$ und eine Selbstjustierung des Risses in der Spaltebene ist für den gesamten Trennprozess zwischen Start- und Zielposition gewährleistet. Eine Ablenkung des Risses, wie sie in Fig. 7 gezeigt ist, wird unterdrückt und die Rissspitze bewegt sich in jedem Zeitpunkt des Trennvorganges $t = t_n + dt$ in die Spaltrichtung $\alpha = 0$, wie in Fig. 14 gezeigt ist.

Die Berechnung der Funktionen $G_-(\alpha)$ und $G_+(\alpha)$ und der Abgleich der Spannungsfelder ist auch iterativ sowie für alle möglichen Kombinationen von bekannten Maximalfehlern bei der Vorjustierung möglich. Die Steuerung und Dimensionierung der Spannungsfelder ist mit den bekannten Verfahren leicht z.B. über Steuerung der Laserleistung und/oder die Variation des Laserfokus und/oder die Anordnung der Kühldüsen zum Laserspot möglich. Aber auch andere Möglichkeiten sind denkbar.

Das Verfahren kann ferner auch so ausgeführt werden, dass beim Schritt der Prüfung der Bedingungen (2.1) oder (2.2) ein maximal zulässiger Winkelbereich $\alpha_1 < \alpha < \alpha_2$ ermittelt wird. In diesem Bereich muss gelten: $\frac{\partial^2 G}{\partial \alpha^2} \le 0$ im Fall von Bedingung (2.1) bzw. $G(\alpha) \ge 2\gamma_e(\alpha)$ im Fall von Bedingung (2.2). Der ermittelte Winkelbereich wird mit einem vorab bekannten und nun vorgegebenen, möglichen Justagefehler einer Ausrichtung der kristallographischen Spaltebene (2') relativ zur Trennvorrichtung verglichen. Die Steuerung der Spannungsfelder (3', 4') und/oder der Anpassung der Vorjustierung wird dann in Abhängigkeit von dem Vergleich vorgenommen.

Die Erfindung ist nicht auf das Trennen von GaAs - Wafern, die als Ausführungsbeispiel beschrieben ist, beschränkt. Sie ist auf alle Einkristalle anwendbar. Angenäherte Zahlenwerte für $CaF_2$ (111)-Fläche sind z.B. $\gamma_s \approx 0.47$ J/m$^2$ (*ab initio* Hartree-Fock Rechnungen) und $\beta_e \approx (3{,}31 - 6.8) \times 10^{-10}$ J/m und mit h = 0.32 nm: $\beta_e/h \approx (1.03 - 2.13)$ J/m$^2$.

Ferner bezieht sich die Erfindung nicht nur auf das Trennen von Scheiben, Wafern oder Teilen davon zur Bildung von Flats. Besonders auch die Vereinzelung von Einkristallen ist von der Erfindung eingeschlossen, die vorher z.B. epitaktisch oder im Rahmen von Abscheideverfahren beschichtet und ggf. lithographisch strukturiert wurden, und/oder aus denen dann beispielsweise integrierte Schaltkreise oder opto-elektronische Bauelemente, insbesondere Laser- oder Lumineszenzdioden hergestellt wurden/werden.

Ferner ist die Erfindung auch auf Einkristalle anwendbar, die als einkristalline Schichten auf einem einkristallinen Substrat gebildet wurden. Schicht und Substrat können dabei aus artgleichem oder auch artfremdem Material gebildet sein.

Im Ausführungsbeispiel wurde eine spezielle Anordnung der Spannungsfelder beschrieben, wobei nämlich die Rissfront im Spannungsfeld zwischen Temperatursenke und Temperaturquelle gehalten wurde. Die Erfindung ist allerdings nicht auf diese spezielle Anordnung beschränkt. Zum Beispiel können Spannungsfelder auch nur durch eine Temperaturquelle oder nur durch eine Temperatursenke vorgesehen sein, und/oder die Rissfront befindet sich nicht hinter sondern vor dieser Senke oder Quelle.

Die Erfindung ist auch als Computerprogrammprodukt umsetzbar, das zur Durchführung und Steuerung der Schritte nach einem der beigefügten Verfahrensansprüche eingerichtet ist.

**Patentansprüche**

1. Verfahren zum Trennen von einkristallinen Schichten, Scheiben oder Wafern oder Teilen davon, mit den Schritten:

   Vorjustieren der kristallographischen Spaltebene (2') zur Spaltvorrichtung;
   Vorgeben einer Spannungsintensität (K) über thermisch oder mechanisch induzierte Spannungsfelder (3', 4') durch Berechnung oder durch Messung;
   Für die vorgegebenen Spannungsfelder (3', 4') Bestimmen der Energiefreisetzungsrate G($\alpha$) bei Rissfortschritt in Abhängigkeit vom möglichen Ablenkwinkel ($\alpha$) von der Spaltebene; und
   Erzeugen der Spannungsfelder (3', 4');
   Steuern oder Regeln, und Positionieren von den die Spannungsfelder (3', 4') erzeugenden Quellen und/oder der Vorjustierung um die berechneten Spannungsfelder einzustellen, wobei im Einkristall eine Rissausbreitung erfolgt, wobei G (0) $\geq$ 2 $\gamma_e$(0) und gleichzeitig zusätzlich mindestens eine der Bedingungen

$$\left|\frac{\partial G}{\partial \alpha}\right|_{\alpha=0} \leq 2\frac{\beta_e}{h} \ \text{ wenn } \ \frac{\partial^2 G}{\partial \alpha^2} \leq 0 \qquad\qquad (2.1)$$

   oder

$$\left|\frac{\partial G}{\partial \alpha}\right| \leq 2\frac{\beta_e}{h} \qquad\qquad \forall \alpha : \alpha_1 < \alpha < \alpha_2 \qquad\qquad (2.2)$$

   erfüllt sind, wobei
   $\alpha$ der mögliche Ablenkwinkel bei Rissfortschritt von der Spaltebene,
   $\alpha_1$, $\alpha_2$ derjenige Winkelbereich, in dem die notwendige Bedingung für Rissausbreitung G($\alpha$) $\geq$ 2 $\gamma_e$($\alpha$) gewährleistet ist,
   G($\alpha$) die Energiefreisetzungsrate in Abhängigkeit von einer Ablenkung des Risses von der Spaltebene um den Winkel $\alpha$,
   $\gamma_e$(0) die effektive Oberflächenenergie der Spaltfläche,
   $\gamma_e$ die richtungsabhängige effektive Oberflächenenergie,
   $\beta_e$ die effektive Stufenenergie (materialspezifisch), und
   h die Stufenhöhe (materialspezifisch) ist.

2. Verfahren nach Anspruch 1, bei dem der Schritt der Steuerung der Spannungsfelder (3', 4') die Schritte beinhaltet, dass
   anhand der für die Spannungsfelder (3', 4') bestimmten Energiefreisetzungsrate G($\alpha$) in Abhängigkeit vom möglichen Ablenkwinkel ($\alpha$) die Gültigkeit von G (0) $\geq$ 2 $\gamma_e$(0) und der wenigstens einen der beiden Bedingungen (2.1) oder (2.2) geprüft wird,
   in Abhängigkeit vom Ergebnis der Prüfung die Spannungsfelder (3', 4') und/oder die Vorjustierung der Spaltebene zur Spaltvorrichtung angepasst werden.

3. Verfahren nach Anspruch 2, bei dem
   der Schritt des Bestimmens der Energiefreisetzungsrate G($\alpha$) für die angepassten Spannungsfelder oder die angepasste Vorjustierung sowie die anschließende Prüfung wiederholt wird, falls zumindest G (0) $\geq$ 2 $\gamma_e$(0) oder eine der Bedingungen (2.1), (2.2) nicht erfüllt ist, und infolgedessen die Spannungsfelder (3', 4') angepasst werden.

4. Verfahren nach einem der Ansprüche 1 bis 3, wobei ein Initialriss (2), vorzugsweise als durchgehender Randriss in Spaltrichtung, erzeugt wird.

5. Verfahren nach einem der Ansprüche 1 bis 4, wobei im Voraus
   die Energiefreisetzungsrate (G) über Simulationsrechnungen in Abhängigkeit vom Winkel ($\alpha$) bestimmt wird, und/oder
   die materialspezifische effektive Stufenenergie ($\beta_e$) und die materialspezifische effektive Stufenhöhe (h) bestimmt und vorgegeben werden, und/oder

die richtungsabhängige effektive Oberflächenenergie ($\gamma_e$) bestimmt und vorgegeben wird.

6. Verfahren nach einem der Ansprüche 1 bis 5, wobei eine Berechnung der Spannungsfelder (3'; 4') im Voraus erfolgt.

7. Verfahren nach einem der Ansprüche 1 bis 6, wobei die Spannungsfelder (3', 4') in der Umgebung der Rissspitze während der Rissausbreitung gemessen und danach für den Schritt des Bestimmens der Energiefreisetzungsrate G($\alpha$) in Abhängigkeit vom möglichen Ablenkwinkel ($\alpha$) vorgegeben werden.

8. Verfahren nach Anspruch 7, bei dem die Spannungsfelder durch Spannungsdoppelbrechung, Mikro-Raman-Spektroskopie oder Ultraschallmikroskopie gemessen werden.

9. Verfahren nach einem der Ansprüche 1 bis 6, wobei die Energiefreisetzungsrate G_($\alpha$) für den Fall der infinitesimalen Rissausbreitung in Abhängigkeit von möglichen Ablenkungen um den Winkel $\alpha$ für das Startgebiet (12) der Rissausbreitung, und die Energiefreisetzungsrate G_+($\alpha$) für das geplante Zielgebiet (13) unter der Annahme, dass der Riss die Spaltebene (2') nicht verlassen hat, berechnet werden und die Spannungsintensität (K) so eingestellt wird, dass die erfindungsgemäßen Bedingungen (2.1) und (2.2) für beide Funktionen G_($\alpha$) und G_+($\alpha$) erfüllt sind.

10. Verfahren nach einem der Ansprüche 1 bis 9, wobei ein Kristall aus der Gruppe der II-VI, der Gruppe der III-V-Halbleiter, speziell ein GaAs-, oder GaP-, oder InP-Einkristall, oder ein Si-Einkristall, oder ein CaF-Einkristall, oder ein SiC- , oder ein Saphir-Einkristall, oder ein GaN-Einkristall, insbesondere eine einkristalline Scheibe dieser Einkristalltypen, getrennt wird.

11. Verfahren nach einem der Ansprüche 1 bis 10, bei dem
ein Maximalwert für den möglichen Justagefehler einer Ausrichtung der kristallographischen Spaltebene (2') relativ zur Trennvorrichtung vorgegeben wird, und
der Schritt des Steuerns der Spannungsfelder (3', 4') und/oder der Anpassung der Vorjustierung einen Vergleich der wenigstens einen einzuhaltenden Bedingung (2.1) oder (2.2) mit einem durch den maximal möglichen Justagefehler repräsentierten Winkelbereich beinhaltet, wobei die Steuerung und/oder die Anpassung in Abhängigkeit von dem Vergleich vorgenommen werden.

## Claims

1. Method of separating single crystal layers, plates or wafers or parts thereof, comprising the steps:

pre-adjusting the crystallographic cleavage plane (2') relative to the cleavage device;
providing a stress intensity (K) by thermally or mechanically induced stress fields (3', 4') via calculation or measurement;
for the provided stress fields (3', 4') determining an energy release rate G($\alpha$) upon crack propagation dependent from a possible deflection angle ($\alpha$) from the cleavage plane (2'); and
generating the stress fields (3', 4');
controlling and positioning of the sources generating the stress fields (3', 4') and/or of the pre-adjustment such that the calculated stress fields (3', 4') are adjusted, wherein crack propagation occurs in the single crystal, wherein G(0) $\geq 2\gamma_e(0)$ and simultaneously at least one of the following conditions is additionally satisfied:

$$\left|\frac{\partial G}{\partial \alpha}\right|_{\alpha=0} \leq 2\frac{\beta_e}{h} \ \text{if} \ \frac{\partial^2 G}{\partial \alpha^2} \leq 0 \tag{2.1}$$

or

$$\left|\frac{\partial G}{\partial \alpha}\right| \leq 2\frac{\beta_e}{h} \qquad \forall \alpha : \alpha_1 < \alpha < \alpha_2 \tag{2.2},$$

wherein:

$\alpha$ denotes the possible deflection angle from the cleavage plane upon crack propagation,

$\alpha_1$, $\alpha_2$ denotes a range of angles, wherein the necessary condition for a crack propagation $G(\alpha) \geq 2\,\gamma_e(\alpha)$ is satisfied,

$G(\alpha)$ denotes the energy-release rate dependent from a deflection of the crack from the cleavage plane about angle $\alpha$,

$\gamma_e(0)$ denotes an effective surface energy of cleavage surface,

$\gamma_e$ denotes an effective surface energy which depends from the direction,

$\beta_e$ denotes an effective step energy (material specific), and

h denotes a step height (material specific).

2. Method according to claim 1, wherein the step of controlling the stress fields includes the following steps:

verifying the validity of $G(0) \geq 2\,\gamma_e(0)$ and the at least one of the conditions (2.1) or (2.2) by means of the energy release rate $G(\alpha)$ obtained for the given stress fields (3', 4') in dependence of possible deflection angles ($\alpha$);

in dependence of the result of the verification adjusting the stress fields (3', 4') and/or the pre-adjustment of the cleavage plane relative to the cleavage device.

3. Method according to claim 2, wherein

the step of determining the energy release rate $G(\alpha)$ for the adjusted stress fields (3', 4') or the adapted pre-adjustment as well as the following step of the verification are repeated, if at least $G(0) \geq 2\gamma_e(0)$ or the at least one of the conditions (2.1) or (2.2) is not fulfilled; and

the stress fields (3', 4') and/or the pre-adjustment are adjusted in response thereto.

4. Method according to one of claims 1 to 3, wherein an initial crack (2) is generated, preferably as a continuous edge-crack directed along the cleavage plane (2').

5. Method according to one of claims 1 to 4, wherein in advance

the energy release rate (G) is determined via simulation calculations in dependence from angle ($\alpha$), and/or

the material specific effective step energy ($\beta_e$) and the material specific step height (h) are determined and provided, and/or

the direction dependent effective surface energy ($\gamma_e$) is determined and provided.

6. Method according to one of claims 1 to 5, wherein a calculation of the stress fields (3', 4') is performed in advance.

7. Method according to one of claims 1 to 6, wherein the stress fields (3', 4') are measured in a vicinity of the tip of the crack during crack propagation, and are provided thereafter for the step of determining the energy release rate $G(\alpha)$ dependent from the deflection angle ($\alpha$).

8. Method according to claim 7, wherein the stress fields are measured by means of stress birefringence, micro-Raman spectroscopy or ultrasonic microscopy.

9. Method according to one of claims 1 to 6, wherein

the energy release rate $G_-(\alpha)$ is calculated for the case of the infinitesimal propagation of the crack in dependence from possible deflections about the angle $\alpha$ for the start region (12) of the crack propagation, and

the energy release rate $G_+(\alpha)$ is calculated for the planned target region (13) under the assumption that the crack has remained within the cleavage plane (2'), and

the stress intensity (K) is adjusted such that conditions (2.1) and (2.2) are fulfilled for both functions $G_-(\alpha)$ and $G_+(\alpha)$.

10. Method according to one of claims 1 to 9, wherein a crystal out of the group of II-VI, the group of III-V semiconductors, specifically a GaAs-, or GaP-, or InP-single crystal, or a Si crystal, or a CaF crystal, or a SiC-, or a sapphire single crystal, or a GaN single crystal, in particular a monocrystalline plate of such types of single crystals, is separated.

11. Method according to one of claims 1 to 10, wherein

a maximum value of the possible adjustment error of an orientation process of the crystallographic cleavage plane (2') is provided relative to the separation device, and

the step of controlling the stress fields (3', 4') and/or the adjustment of the pre-adjustment include a comparison of the at least one condition (2.1) or (2.2) to be fulfilled with a range of angles representing the maximum possible adjustment error, wherein the control and/or adjustment is performed dependent from the comparison.

**Revendications**

1. Procédé de coupe de couches, disques ou tranches monocristallins ou des parties de ceux-ci, comportant les étapes :

   alignement préliminaire du plan de coupe (2') cristallographique par rapport au dispositif de coupe ;
   définition, par calcul ou par mesure, d'une intensité de contrainte (K) via les champs de contrainte (3', 4') à induction thermique ou mécanique ;
   pour les champs de contrainte (3', 4') définis, détermination du taux de libération d'énergie $G(\alpha)$ en présence d'une propagation de la fissure, en fonction de l'angle de déviation ($\alpha$) possible du plan de coupe ; et création des champs de contrainte (3', 4') ;
   commande ou réglage, et positionnement des sources générant les champs de contrainte (3', 4') et/ou de l'alignement préliminaire pour régler les champs de contrainte calculés,
   une propagation de la fissure se produisant dans le monocristal,
   $G(0)$ étant $\geq 2\,\gamma_e(0)$ et, en même temps, sont remplies, en plus, au moins une des conditions suivantes :

$$\left|\frac{\partial G}{\partial \alpha}\right|_{\alpha=0} \leqslant 2\frac{\beta_e}{h} \text{ lorsque } \frac{\partial^2 G}{\partial \alpha^1} \leqslant 0 \qquad\qquad (2.1)$$

ou

$$\left|\frac{\partial G}{\partial \alpha}\right| \leq 2\frac{\beta_e}{h} \qquad\qquad \forall\alpha : \alpha_1 < \alpha < \alpha_2 \qquad\qquad (2.2)$$

   dans lesquelles
   $\alpha$ est l'angle de déviation possible par rapport au plan de coupe en cas de propagation de la fissure,
   ($\alpha_1$, $\alpha_2$ est la zone angulaire dans laquelle est garantie la condition nécessaire à la propagation de la fissure $G(\alpha) \geq 2\,\gamma_e(\alpha)$,
   $G(\alpha)$ est le taux de libération d'énergie en fonction d'une déviation de la fissure par rapport au plan de coupe selon l'angle $\alpha$,
   $\gamma_e(0)$ est l'énergie superficielle effective de la surface de coupe,
   $\gamma_e$ est l'énergie superficielle effective en fonction de la direction, $\beta_e$ est l'énergie effective de marches (spécifique au matériau), et h est la hauteur de marches (spécifique au matériau).

2. Procédé selon la revendication 1, **caractérisé en ce que** l'étape de la commande des champs de contrainte (3', 4') contient les étapes, selon lesquelles
   sur la base du taux de libération d'énergie $G(\alpha)$, déterminé pour les champs de contrainte (3', 4'), en fonction de l'angle de déviation ($\alpha$) possible, est vérifiée la validité de $G(0) \geq 2\,\gamma_e(0)$ et d'au moins une desdites deux conditions (2.1) ou (2.2),
   les champs de contrainte (3', 4') et/ou l'alignement préliminaire du plan de coupe par rapport au dispositif de coupe sont ajustés en fonction du résultat de la vérification.

3. Procédé selon la revendication 2, **caractérisé en ce que**, dans le cas où au moins $G(0) \geq 2\,\gamma_e(0)$ ou une des conditions (2.1), (2.2) n'est pas rempli, on réitère l'étape de la détermination du taux de libération d'énergie $G(\alpha)$, pour les champs de contrainte ajustés ou l'alignement préliminaire ajusté, ainsi que la vérification consécutive desdites conditions (2.1), (2.2) ou bien que $G(0) \geq 2\,\gamma_e(0)$, les champs de contrainte (3', 4') étant ajustés en conséquence.

4. Procédé selon l'une quelconque des revendications 1 à 3, **caractérisé en ce qu'**une fissure initiale (2), de préférence sous forme de fissure continue du bord dans le sens de coupe, est générée.

5. Procédé selon l'une quelconque des revendications 1 à 4, **caractérisé en ce qu'**au préalable le taux de libération d'énergie (G) est déterminé par des calculs de simulation en fonction de l'angle ($\alpha$), et/ou l'énergie effective de marches ($\beta_e$) spécifique au matériau et la hauteur effective de marches (h) spécifique au matériau sont déterminées et définies, et/ou l'énergie superficielle effective ($\gamma_e$) fonction de la direction est déterminée et définie.

6. Procédé selon l'une quelconque des revendications 1 à 5, **caractérisé en ce qu'**un calcul des champs de contrainte (3', 4') est effectué au préalable.

7. Procédé selon l'une quelconque des revendications 1 à 6, **caractérisé en ce que** les champs de contrainte (3', 4') sont mesurés dans l'environnement des sommets de la fissure pendant la propagation de la fissure et sont définis ensuite pour l'étape de la détermination du taux de libération d'énergie G($\alpha$) en fonction de l'angle de déviation ($\alpha$) possible.

8. Procédé selon la revendication 7, **caractérisé en ce que** les champs de contrainte sont mesurés au moyen de la biréfringence par compression, de la microspectroscopie Raman ou de la microscopie ultrasonore.

9. Procédé selon l'une quelconque des revendications 1 à 6, **caractérisé en ce que** l'on calcule le taux de libération d'énergie G-($\alpha$) dans le cas de la propagation infinitésimale de la fissure en fonction des déviations possibles selon l'angle ($\alpha$) pour la zone de départ (12) de la propagation de la fissure, et le taux de libération d'énergie $G_+(\alpha)$ pour la zone cible (13) prévue en supposant que la fissure ne quitte pas le plan de coupe (2'), et on règle l'intensité de contrainte (K) de telle sorte que les conditions (2.1) et (2.2) selon l'invention sont remplies pour les deux fonctions $G_-(\alpha)$ et $G_+(\alpha)$.

10. Procédé selon l'une quelconque des revendications 1 à 9, **caractérisé en ce que** l'on coupe un cristal issu du groupe des semi-conducteurs II-IV, du groupe des semi-conducteurs III-V, spécialement un monocristal de GaAs, ou de GaP ou de InP ou un monocristal de silicium ou un monocristal de CaF, ou un monocristal de SiC ou un monocristal de saphir, ou un monocristal de GaN, en particulier un disque monocristallin de ces types de monocristaux.

11. Procédé selon l'une quelconque des revendications 1 à 10, **caractérisé en ce que** on définit une valeur maximale pour le défaut d'alignement possible d'une orientation du plan de coupe (2') cristallographique par rapport au dispositif de coupe, et l'étape de la commande des champs de contrainte (3', 4') et/ou de l'ajustement de l'alignement préliminaire contient une comparaison d'au moins une desdites conditions (2.1) ou (2.2) à respecter avec une zone angulaire représentée par le défaut d'alignement possible au maximum, la commande et/ou l'ajustement étant effectués en fonction de la comparaison.

Fig. 1

Fig.2

Fig.3

Fig.4

Fig.5

$G(0)=2\gamma_e(0)$

$t = t_0$

**Fig. 6**

$G = 2\gamma_e$

$t = t_0+\Delta t$

**Fig. 7**

$\overline{dr} \longrightarrow 6$

1

$3^l$

$5$

$\alpha_f$

$4^l$

$P(0)$

$P(t_0 + dt)$

$G(\alpha_f) = 2\gamma(\alpha_f)$

$t = t_0 + dt$

Fig. 8

$\overline{dr} \longrightarrow 6$

1

$3^l$

$\alpha$

$4^l$

$P(0)$

$G(\alpha = 0) = 2\gamma(\alpha = 0)$

$P(t_0 + dt)$

$t = t_0 + dt$

Fig. 9

7  8
2
6
9
$[01\bar{1}]$
12
10
11
13
9
$2^I$
$[0\bar{1}\bar{1}]$

(100)

Fig. 10

12

$d\vec{r}$  6

5  $\alpha$

$3^I$  $4^I$

$t = t_0$

$G_-(\alpha = 0) > 2\gamma_e(\alpha = 0)$

Fig. 11

Fig. 12

$$G_+(\alpha = 0) > 2\gamma_e(\alpha = 0)$$

Fig. 13

Fig.14

$$G(\alpha = 0) = 2\gamma_e(\alpha = 0)$$

$$t = t_n + dt$$

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 5279077 A
- US 5439723 A
- US 5154333 A
- DE 2813302
- WO 9320015 A

### In der Beschreibung aufgeführte Nicht-Patentliteratur

- **BELSINGER H E JR et al.** A fracture criterion for gallium arsenide wafers. *ENGINEERING FRACTURE MECHANICS UK,* Mai 1994, vol. 48 (2), ISSN 0013-7944, 199-205
- **QIAN, G.X. ; MARTIN, R.M. ; CHADI, D.J.** *Phys. Rev. B,* 1988, vol. 37, 1303
- **BECHSTEDT, F.** Principles of Surface Physics. Springer Verlag, 16-18